# EUROPÄISCHE PATENTSCHRIFT

(11) **EP 4 240 593 B1**
(45) Veröffentlichungstag und Bekanntmachung des Hinweises auf die Patenterteilung: **20.11.2024**
(21) Anmeldenummer: 21802302.6
(22) Anmeldetag: 28.10.2021
(51) Int. Cl.: B41J 3/407, B41J 25/00, B41J 2/145, H01L 31/0224, H01L 31/18, H05K 1/09, H05K 3/12

(54) **VORRICHTUNG UND VERFAHREN ZUM SEGMENTIERTEN PARALLELDISPENSEN**
DEVICE AND METHOD FOR SEGMENTED PARALLEL DISPENSING
DISPOSITIF ET PROCÉDÉ POUR UNE DISTRIBUTION PARALLÈLE SEGMENTÉE

(30) Priorität: 06.11.2020 DE 102020129305
(43) Veröffentlichungstag der Anmeldung: 13.09.2023
(73) Patentinhaber: Fraunhofer-Gesellschaft zur Förderung der angewandten Forschung e.V., 80686 München (DE)
(72) Erfinder: POSPISCHIL, Maximilian, 79110 Freiburg (DE); KUCHLER, Martin, 79110 Freiburg (DE); BREITENBÜCHER, Marian, 79110 Freiburg (DE); RIEBE, Tim, 79110 Freiburg (DE); TEPNER, Sebastian, 79110 Freiburg (DE); CLEMENT, Florian, 79110 Freiburg (DE); WEIL, Maximilian, 79199 Freiburg (DE); GENSOWSKI, Katharina, 51789 Lindlar (DE); JIMENEZ CARDOZO, Ana Maria, Cali (CO)
(74) Vertreter: LBP Lemcke, Brommer & Partner Patentanwälte mbB
(86) Internationale Anmeldenummer: PCT/EP2021/080047
(87) Internationale Veröffentlichungsnummer: WO 2022/096372

(56) Entgegenhaltungen:
- EP-A2- 2 626 915
- WO-A1-2010/061394
- WO-A1-2019/188969
- US-A1- 2009 027 430
- US-A1- 2012 244 284

## Beschreibung

Die Erfindung betrifft eine Vorrichtung zum Paralleldispensen eines Druckmediums gemäß Anspruch 1 sowie ein Verfahren zum Paralleldispensen eines Druckmediums gemäß Anspruch 13.

Bei industriellen Druckvorgängen, insbesondere bei der Herstellung von Halbleiterstrukturen, wie beispielsweise fotovoltaischen Solarzellen, ist es häufig wünschenswert, ein Druckmedium in zumindest zwei parallelen Bahnen auf ein Substrat, insbesondere ein Halbleitersubstrat, aufzubringen. Solch ein Druckmedium kann eine Druckpaste sein, welche insbesondere einen Dotierstoff zur Dotierung eines oder mehrerer Bereiche der Halbleiterstruktur enthält, welche zur Ausbildung einer Maskierung für nachfolgende Prozessschritte dient und/oder welche Metallpartikel zum Ausbilden einer metallischen Kontaktstruktur enthält.

Um die Druckpaste auf das Substrat aufzutragen, wird das Druckmedium mittels einer Pumpeinheit in eine Mehrzahl an Dispenserdüsen der Druckeinheit gefördert, während die Druckeinheit in einer Relativbewegung mit einer Bewegungsrichtung gegenüber dem Substrat verlagert wird. Das Druckmedium tritt dabei aus den Dispenserdüsen auf die Oberfläche des Substrates, wobei die Dispenserdüsen jeweils eine Drucklinie erzeugen, welche entsprechend der Bewegungsrichtung der Relativbewegung auf dem Substrat verläuft. Um eine Mehrzahl parallel verlaufender Drucklinien auf dem Substrat in kurzer Zeit aufzutragen, ist es bekannt, zumindest zwei Dispenserdüsen einer Druckeinheit derart anzuordnen, dass sie quer zu einer Bewegungsrichtung voneinander beabstandet sind. Dadurch ist es möglich, lediglich eine geradlinige Relativbewegung zu erzeugen, wobei gleichzeitig mehr als nur eine Drucklinie erzeugt wird. Eine solche Druckeinheit ist aus WO 2010/061394 A1 und DE 10 2013 223 250 A1 bekannt

Zur Steigerung der Produktivität industrieller Druckvorgänge ist es wünschenswert, die Zeit, welche erforderlich ist, um die Gesamtheit aller Drucklinien, insbesondere bis zu insgesamt 200 Drucklinien, auf das Substrat aufzubringen, zu verringern. Eine Möglichkeit, dies zu erreichen, liegt in der Ausgestaltung leistungsstarker Antriebsmittel mit denen die Geschwindigkeit erhöht werden kann, mit welcher die Druckeinheit und das zu bedruckende Substrat gegenüber einander bewegt werden, während die Drucklinien auf das Substrat aufgebracht werden. Derart leistungsstarke Antriebsmittel gehen allerdings mit einer hohen technischen Komplexität und/oder hohen Kosten einher.

Der vorliegenden Erfindung liegt daher die Aufgabe zugrunde, die Produktivität industrieller Druckvorgänge zu erhöhen und die dafür erforderlichen Kosten gleichzeitig niedrig zu halten. Gelöst ist diese Aufgabe durch eine Vorrichtung zum Paralleldispensen von Druckmedium gemäß Anspruch 1 sowie durch ein Verfahren gemäß Anspruch 13. Vorteilhafte Ausgestaltungen finden sich in den abhängigen Unteransprüchen.

Die erfindungsgemäße Vorrichtung zum Paralleldispensen eines Druckmediums auf ein Substrat, insbesondere zur Herstellung einer oder mehrerer Leiterbahnen auf einem Halbleitersubstrat, umfasst eine Druckeinheit mit einer Mehrzahl von Dispenserdüsen zur gleichzeitigen Ausgabe des Druckmediums. Ferner umfasst die erfindungsgemäße Vorrichtung ein Antriebsmittel, welches dazu ausgestaltet ist, eine Relativbewegung zwischen der Druckeinheit und dem Substrat in einer Bewegungsrichtung zu erzeugen, wobei zumindest eine erste Dispenserdüse und eine zweite Dispenserdüse quer zur Bewegungsrichtung voneinander beabstandet angeordnet sind.

Wesentlich für die erfindungsgemäße Vorrichtung ist, dass die erste Dispenserdüse und eine dritte Dispenserdüse der Druckeinheit entlang einer gemeinsamen ersten Längsachse in einem ersten Düsenabstand voneinander beabstandet angeordnet sind, wobei die erste Längsachse parallel zu der Bewegungsrichtung verläuft.

Es ist eine erfindungswesentliche Erkenntnis der Anmelder, dass die Produktivität industrieller Druckverfahren gegenüber bekannten Vorrichtungen und Verfahren deutlich erhöht werden kann, indem die Dispenserdüsen einer Druckeinheit in Abhängigkeit der Bewegungsrichtung der Relativbewegung angeordnet werden.

Ein Vorteil wird, wie an sich aus dem Stand der Technik bekannt, dadurch erreicht, dass die erste und die zweite Dispenserdüse auf der Druckeinheit quer zur Bewegungsrichtung voneinander beabstandet angeordnet sind. Bei Durchführung der Relativbewegung erzeugt das Druckmedium, welches aus der ersten Dispenserdüse und der zweiten Dispenserdüse austritt, eine erste Drucklinie bzw. eine zweite Drucklinie auf dem Substrat. Die erste Drucklinie und die zweite Drucklinie sind dabei entsprechend dem Abstand zwischen der ersten und der zweiten Dispenserdüse parallel voneinander beabstandet und weisen einen eigenen ersten bzw. zweiten Startpunkt und einen ersten bzw. zweiten Endpunkt auf.

Es grundsätzlich unerheblich, ob die erste Dispenserdüse und die zweite Dispenserdüse in Bewegungsrichtung auf gleicher Höhe, also in einer gemeinsamen Reihe aus Dispenserdüsen, welche orthogonal zur Bewegungsrichtung verläuft, angeordnet sind. Vielmehr ergibt sich der Vorteil dieser quer zueinander beabstandeten Dispenserdüsen in an sich bekannter Weise daraus, dass die Druckeinheit und das Substrat in einer einzigen Relativbewegung gegenüber einander verlagert werden können, wobei gleich zwei parallel zueinander beabstandete Drucklinien erzeugt werden.

Die erfindungswesentliche Erkenntnis der Anmelderin betrifft jedoch die Anordnung einer dritten Dispenserdüse auf der Druckeinheit. Diese ist entlang der ersten Längsachse vor oder hinter der ersten Dispenserdüse angeordnet. Dies führt dazu, dass während der Relativbewegung zwischen Druckeinheit und Substrat neben der ersten und der zweiten Drucklinie, eine dritte Drucklinie erzeugt wird, welche koaxial zu der ersten Drucklinie verläuft.

Der wesentliche Vorteil dieser Anordnung ist darin zu sehen, dass die erste und die dritte Drucklinie in einfacher Weise durch geeignete Steuerung der Antriebsmittel derart auf das Substrat aufgebracht werden können, dass besagte Drucklinien sich in einem gemeinsamen Kontaktpunkt berühren und die beiden Drucklinien eine durchgehende Drucklinie erzeugen oder bedarfsweise durch eine Lücke voneinander beabstandet oder sogar überlappend angeordnet sind.

Die erste Längsachse ist eine reine Orientierungsachse, welche körperfest an einer Oberfläche der Druckeinheit verläuft und insbesondere während der Konstruktion zur Anordnung zumindest der ersten und der dritten Dispenserdüse auf der Druckeinheit dienen kann. Besagte Anordnung der ersten und der dritten Dispenserdüse kann dadurch charakterisiert sein, dass die erste und die dritte Dispenserdüse anhand identischer geometrischer Merkmale, wie z.B. ihrem jeweiligen Düsenmittelpunkt oder einem Randpunkt einer Düsenöffnung jeweils entlang der ersten Längsachse angeordnet werden.

Es liegt auch im Rahmen der Erfindung, dass zumindest die erste und die dritte Dispenserdüse unterschiedliche geometrische Merkmale aufweisen, anhand derer sie entlang der ersten Längsachse angeordnet sind. Zur Verkörperung der erfindungsgemäßen Erkenntnis ist es hierbei ausreichend, dass die erste und die dritte Dispenserdüse bei der Relativbewegung mit ihren jeweiligen Düsenöffnungen in Blickrichtung entlang der Bewegungsrichtung zumindest teilweise fluchtend angeordnet sind, sodass durch eine Relativbewegung der Druckeinheit gegenüber dem Substrat bei gleichzeitiger Ausgabe des Druckmediums durch die erste und die dritte Dispenserdüse theoretisch eine ununterbrochene Drucklinie erzeugt werden kann.

Die Relativbewegung kann erfindungsgemäß auf verschiedene Weisen realisiert sein, welche jeweils davon abhängen, wie das Antriebsmittel ausgestaltet ist und in welcher Art und Weise diese steuerbar sind, um die Relativbewegung zu erzeugen.

In der einfachsten Ausführungsform handelt es sich bei dem Antriebsmittel um eine Lineareinheit mit einer Linearführung und einem angetriebenen Schlitten, mittels welchem entweder die Druckeinheit oder das Substrat geradlinig relativ zueinander bewegt werden. Die Relativbewegung weist dabei eine Bewegungsrichtung und einen relativen Verfahrweg auf. Die Bewegungsrichtung ergibt sich aus der Orientierung der Linearführung sowie der Start- und Endposition des darauf bewegten Schlittens. Der relative Verfahrweg ergibt sich in Abhängigkeit der Positionen, in denen die Druckeinheit sich bei Beginn und bei Beendigung des Druckvorganges befindet.

In einer anderen Ausführungsform umfasst das Antriebsmittel mehrere Lineareinheiten oder andere Positioniereinheiten, mit denen sowohl die Druckeinheit als auch das Substrat gleichzeitig oder nacheinander gegenüber einander bewegt werden können, um die Relativbewegung zu erzeugen. Die Bewegungsrichtung ergibt sich dabei daraus, in welcher Richtung die Dispenserdüsen das Substrat während der Relativbewegung überstreichen. Der relative Verfahrweg entspricht stets der Länge eines Bereiches, welcher von einer einzelnen Dispenserdüse überstrichen wird. Hierbei ist es unerheblich, um welche Dispenserdüse der Druckeinheit es sich handelt, da die Dispenserdüsen körperfest der Dispensereinheit angeordnet sind und damit zumindest im Fall einer einteilig ausgeführten Druckeinheit alle denselben relativen Verfahrweg zurücklegen.

Unabhängig von der Ausführungsform der Antriebsmittel sind diese derart ausgestaltet, dass der relative Verfahrweg zur Durchführung eines Druckvorganges in seiner Gesamtlänge variabel eingestellt werden kann. Dabei kann der relative Verfahrweg dem ersten Düsenabstand entsprechen oder jedoch kleiner oder größer als dieser sein.

Durch Einstellung eines relativen Verfahrwegs, welcher dem ersten Düsenabstand entspricht, kann durch Auftrag des Druckmediums mittels der ersten und der dritten Dispenserdüse und der sich ergebenden ersten bzw. dritten Drucklinie eine zusammenhängende Drucklinie mit einer Länge erzeugt werden, die exakt doppelt so lange ist, wie der relative Verfahrweg. Hierdurch wird die Produktivität des Druckvorganges zumindest in Bezug auf die zusammengesetzte Drucklinie gegenüber bekannten Vorrichtung und Verfahren um 100% gesteigert. Ein besonderer Vorteil ergibt sich durch die Produktivitätssteigerung bei dem Auftrag von Niedertemperaturpasten auf Halbleitersubstrate, deren Auftrag auf optimale Weise mit ca. 200 Millimeter pro Sekunde optimale Ergebnisse in Bezug auf die Qualität der dadurch erzeugten Drucklinien erreichbar ist. Durch Anordnung mindestens zweier Dispenserdüsen ist es möglich, die optimale Ablegegeschwindigkeit nicht zu verändern und damit trotz einer deutlichen Steigerung der Produktivität keine Qualitätseinbußen hervorzurufen.

Durch weitere Erhöhung der Anzahl der Dispenserdüsen entlang der ersten Längsachse auf eine Düsenanzahl größer als zwei kann die Produktivität weiter erhöht werden, da sich der erforderliche relative Verfahrweg zur Erzeugung einer durchgehenden Drucklinie um denselben Faktor reduziert wird, welcher der Anzahl der hintereinander angeordneten Dispenserdüsen entspricht.

Durch Einstellung eines relativen Verfahrweges, welcher größer als der erste Düsenabstand ist, lässt sich zumindest durch die erste und die dritte Drucklinie eine durchgehende Drucklinie mit einem Überlappungsbereich erzeugen. Eine derartige Zusammensetzung zweier Drucklinien kann insbesondere vorteilhaft sein, wenn es sich bei den Drucklinien um Kontaktierungsfinger zur elektrischen Verschaltung eines Halbleitersubstrats handelt. Untersuchungen der Anmelderin haben ergeben, dass die Ausbildung eines Überlappungsbereiches zwischen zwei koaxial verlaufenden Drucklinien die Stromleitungseigenschaften der sich ergebenden zusammengesetzten Drucklinie verbessert, indem der ohmsche Widerstand verringert wird. Sofern es sich bei dem Halbleitersubstrat um eine herzustellende Solarzelle handelt, gehen die erhöhten Stromleitungseigenschaften auch mit einer verbesserten elektrischen Leistungsfähigkeit der späteren Solarzelle einher.

Durch Einstellung eines relativen Verfahrweges, welcher kleiner ist als der erste Düsenabstand, so sind die erste und die dritte Drucklinie nach Beendung der Relativbewegung koaxial voneinander beabstandet angeordnet. Dies bedeutet, dass die erste und die dritte Drucklinie zwar jeweils entlang der ersten Längsachse orientiert sind, der erste Endpunkt und der dritte Startpunkt der entsprechenden Drucklinien jedoch einen Abstand zueinander aufweisen, der der Differenz zwischen dem eingestellten relativen Verfahrweg und dem ersten Düsenabstand entspricht. Sofern es sich bei dem Substrat um ein Halbleitersubstrat handelt, lässt sich durch eine derartige Anordnung zumindest der ersten und der dritten Drucklinie eine einfache Segmentierung der Solarzelle erreichen, wobei die erste und die dritte Drucklinie getrennt voneinander elektrisch kontaktiert werden.

Im Übrigen ist es grundsätzlich unerheblich, in welcher Art und Weise die Druckeinheit und die Dispenserdüsen ausgestaltet sind. In einer einfachen Ausführungsform kann die Druckeinheit in an sich bekannter Weise als metallischer Druckkopf mit einer bevorzugt quaderförmigen Grundform ausgeführt sein. Die Dispenserdüsen können dabei jeweils als zylindrische oder nichtzylindrische Bohrungen unmittelbar in dem Druckkopf ausgestaltet sein oder als einsteckbare Buchse in einer derartigen Bohrung angeordnet sein. Eine Pumpvorrichtung dient dazu, das Druckmedium in die Dispenserdüsen zu fördern, durch welche das Druckmedium auf eine Oberfläche des Substrats gelangt.

In einer vorteilhaften Weiterbildung sind die erste Dispenserdüse und die zweite Dispenserdüse entlang einer gemeinsamen ersten Querachse angeordnet, wobei die erste Querachse orthogonal zur Bewegungsrichtung verläuft und die erste Querachse die Druckeinheit in einer Weise begrenzt, dass die Druckeinheit auf einer Seite der ersten Querachse frei von weiteren Dispenserdüsen ist.

Die erste Querachse ist analog zur ersten Längsachse eine konstruktive Orientierungsachse, welche die Anordnung der ersten und der zweiten Dispenserdüse auf der Druckeinheit gegenüber der Bewegungsrichtung der Relativbewegung beschreibt.

Der Vorteil, der sich durch die Anordnung der ersten und zweiten Dispenserdüse entlang der ersten Querachse ergibt, ist darin zu sehen, dass die erste und die zweite Drucklinie jeweils einen Start und Endpunkt aufweisen, die auf dem Substrat in Bewegungsrichtung auf gleicher Höhe aufgebracht werden. Insbesondere für die Herstellung metallischer Kontaktstrukturen auf Halbleitersubstraten ist dies vorteilhaft, da insbesondere mehrere derart angeordneter Start- und Endpunkte mittels einer gemeinsamen und geradlinigen Busbar elektrisch kontaktiert werden können.

Ferner ist der Verlauf der ersten Querachse sowohl für die Konstruktion als auch für die Montage der Druckeinheit in der Vorrichtung zum Paralleldispensen vorteilhaft. In der Konstruktion ergibt sich der Vorteil insbesondere daraus, dass die erste Querachse eine Bezugsachse darstellen kann, anhand derer die übrigen Dispenserdüsen der Druckeinheit ausgerichtet werden können und einen eindeutig begrenzten Konstruktionsraum definiert. Für die Montage ist der Verlauf der ersten Querachse deswegen vorteilhaft, da auch unerfahrene Montagekräfte alleine durch Betrachtung des Verlaufs der ersten und zweiten Dispenserdüsen eine Aussage darüber treffen können, in welcher Ausrichtung die Druckeinheit in der Vorrichtung anzubringen und zu befestigen ist.

In einer vorteilhaften Weiterbildung weist die Druckeinheit einen Mittenbereich auf, in dem eine Vielzahl an Dispenserdüsen, umfassend die erste, zweite und dritte Dispenserdüse, entlang mehrerer parallel zueinander verlaufender Reihen angeordnet sind, wobei die erste und die dritte Dispenserdüse in einer gemeinsamen ersten Reihe angeordnet sind und die zweite Dispenserdüse in einer anderen Reihe angeordnet ist, und alle Dispenserdüsen einer Reihe des Mittenbereich regelmäßig in dem ersten Düsenabstand voneinander beabstandet sind.

Es ist eine wesentliche Erkenntnis der Anmelderin, dass es mit Vorteilen einhergeht, wenn die Dispenserdüsen einer Druckeinheit zumindest bereichsweise, vorliegend als Mittenbereich betitelt, in einer regelmäßigen Anordnung zueinander angeordnet sind. Dadurch wird der erfindungsgemäße Vorteil zweier in Bewegungsrichtung hintereinander angeordneter Dispenserdüsen vervielfacht.

Dabei weist der Mittenbereich mindestens zwei Reihen auf, wobei die erste und die dritte Dispenserdüse in der ersten Reihe in dem ersten Düsenabstand zueinander angeordnet sind. Eine andere Reihe, welche zu der ersten Reihe parallel beabstandet ist, umfasst die zweite Dispenserdüse und zumindest eine weitere Dispenserdüse, wobei zumindest diejenige Reihe, welche die zweite Dispenserdüse umfasst, eine zu der ersten Reihe identische Struktur aufweist.

Sofern die erste Dispenserdüse und die zweite Dispenserdüse auf der gemeinsamen ersten Querachse angeordnet sind, ergibt sich durch die einheitlichen Beabstandung zwischen jeweils zwei benachbarten Dispenserdüsen einer Reihe eine matrixartige Anordnung an Dispenserdüsen.

Der Vorteil einer derartigen matrixartigen Anordnung, ist, dass mehrere parallel zueinander verlaufende Drucklinien wahlweise jeweils als eine zusammenhängende Drucklinie oder als eine Mehrzahl koaxial zueinander beabstandeter Teilsegmente erzeugt werden können. Dies ergibt sich in Abhängigkeit davon, wie der relative Verfahrweg in Bezug auf den ersten Düsenabstand gewählt wird. Durch Einstellung eines relativen Verfahrweges, welcher geringer ist als der erste Düsenabstand ergibt sich infolge der matrixartigen Anordnung der Dispenserdüsen im Mittenbereich durch den Druckvorgang eine Schar mehrere parallel verlaufender Drucklinien, welche jeweils durch zumindest eine Lücke unterbrochen sind. Durch Einstellung eines relativen Verfahrweges, welcher dem ersten Düsenabstand entspricht oder größer ist als dieser, ergibt sich infolge der matrixartigen Anordnung der Dispenserdüsen im Mittenbereich durch den Druckvorgang eine Schar mehrerer parallel verlaufender Drucklinien, welche sich jeweils ununterbrochen über den zu bedruckenden Bereich des Substrates erstrecken und ggf. jeweils einen Überlappungsbereich aufweisen.

Es liegt im Rahmen der vorteilhaften Weiterbildung, dass der Mittenbereich mehr als zwei Reihen an Dispenserdüsen umfasst und dass eine dieser Reihen jeweils mehr als zwei Dispenserdüsen umfasst. Vorteilhafterweise sind alle Reihen, welche im Mittenbereich angeordnet sind, regelmäßig voneinander beabstandet, sodass der Mittenbereich durch ein durchgehendes Matrixraster charakterisiert ist, in dem die Dispenserdüsen angeordnet sind. Ein derartiges Matrixraster ist für die Herstellung der Druckeinheit insbesondere mittels automatisierter Bearbeitungsverfahren vorteilhaft.

In einer vorteilhaften Weiterbildung beträgt die Anzahl der Reihen in dem Mittenbereich mindestens 60, vorzugsweise mindestens 80, höchstvorzugsweise mindestens 100.

Untersuchungen der Anmelderin haben gezeigt, dass die Gesamtanzahl an Reihen bei gängigen Abmessungen zu bedruckender Substrate, insbesondere Halbleitersubstrate, mindestens 60 betragen sollte, um eine überdurchschnittliche Steigerung der Produktivität gegenüber bekannten Vorrichtungen und Verfahren zum Paralleldispensen zu erreichen. Insbesondere können die Reihen zumindest bereichsweise in gleichmäßigen Abständen über eine Gesamtbreite der Druckeinheit verteilt sein. In einer vorteilhaften Weiterbildung weist eine Reihe des Mittenbereiches insgesamt genau zwei Dispenserdüsen auf, welche in dem ersten Düsenabstand voneinaner beabstandet sind.

Untersuchungen der Anmelderin haben gezeigt, dass ein guter Kompromiss zwischen den Herstellungskosten einer Druckeinheit und den Kosten eines Antriebsmittels gefunden werden kann, wenn die Anzahl an Dispenserdüsen innerhalb einer Reihe des Mittebereiches die Anzahl von zwei nicht übersteigt. Insbesondere ist dies vorteilhaft, wenn der erste Düsenabstand zwischen den Dispenserdüsen einer Reihe etwa die Hälfte einer zu bedruckenden Substratabmessung beträgt, abzüglich etwaiger Randabstände.

Zu bedruckende Substrate, insbesondere Halbleitersubstrate, weisen in der Regel eine rechteckförmige oder quadratische Grundform mit einer Grundfläche auf. Diese kann durch eine Mehrzahl an Dispenserdüsen, welche in einem Mittenbereich einer Druckeinheit angeordnet sind, zwischen zwei parallel verlaufenden Kanten besagter Grundform mit Drucklinien bedruckt werden ohne darauf Rücksicht nehmen zu müssen, dass einzelne Dispenserdüsen über das Substrat hinausragen könnten. Hierdurch könnten die Ränder des Substrates ungewollt bedruckt oder die Vorrichtung verschmutzt werden.

Allerdings existieren auch zu bedruckende Substrate, welche in Richtung der aufzubringenden Drucklinien bereichsweise unterschiedliche Abmessungen aufweisen. Insbesondere Halbleitersubstrate können neben einer rechteckigen oder quadratischen Grundform eine sog. Pseudo-Square-Form aufweisen. Bei der Pseudo-Square-Form handelt es sich um eine rechteckige Grundform mit abgefasten (auch: abgerundeten) Ecken. Die abgefasten Ecken führen dazu, dass das zu bedruckende Halbleitersubstrat mindestens zwei Bereiche aufweist, in denen die Kontaktierungsfinger in verschiedenen Längen und/oder in unterschiedlichen Bereichen aufgebracht werden müssen.

Bekannte Vorrichtungen und Verfahren lösen diese technische Problemstellung, indem einzelne Dispenserdüsen einer Druckeinheit, welche während des Druckvorganges jenseits des Substrates hinausragen, aktiv z.B. mittels eines Ventils, das den entsprechenden Dispenserdüsen zugeordnet ist, für einen Druckmediumdurchfluss gesperrt werden. Alternativ oder zusätzlich werden Schablonen verwendet, welche am Rand des Substrats und/oder jenseits besagten Randes angeordnet werden, sodass der Druckmittelaustritt aus ausgewählten Dispenserdüsen einer Druckeinheit bereichsweise behindert wird. Nachteiligerweise gehen Absperrventile mit hohen Kosten und einem hohen Steuerungsaufwand einher, während Schablonen einen hohen Reinigungsaufwand erfordern.

In einer vorteilhaften Weiterbildung der Erfindung werden diese Nachteile behoben, indem zumindest eine vierte Dispenserdüse auf einer zweiten Längsachse angeordnet ist, wobei die erste Längsachse und die zweite Längsachse parallel zueinander beabstandet verlaufen und die erste und die vierte Dispenserdüse entlang einer gemeinsamen Schrägachse angeordnet sind, wobei die Schrägachse in einem Winkel zwischen Null Grad und Neunzig Grad zur Bewegungsrichtung verläuft und die Schrägachse die Druckeinheit in einer Weise begrenzt, dass die Druckeinheit auf einer Seite der Schrägachse, vorzugsweise in einem Bereich zwischen der ersten und zweiten Längsachse, frei von weiteren Dispenserdüsen ist.

Die zweite Längsachse sowie die Schrägachse sind analog zu der ersten Längsachse und der ersten Querachse gedachte Orientierungsachsen, entlang derer zumindest die vierte Dispenserdüse angeordnet werden.

Die Orientierung der zweiten Längsachse gewährleistet dabei, dass die vierte Dispenserdüse während der Relativbewegung durch Ausgabe des Druckmediums eine vierte Drucklinie erzeugt, welche parallel zu der ersten Drucklinie verläuft. Hierbei unterscheidet sich die Anordnung der vierten Dispenserdüse sich grundsätzlich nicht von der Anordnung der zweiten Dispenserdüse gegenüber der ersten Dispenserdüse. Die Orientierung der Schrägachse gewährleistet jedoch, dass die erste oder die vierte Dispenserdüse in Bewegungsrichtung nicht auf gleicher Höhe liegen. Da die Schrägachse die Druckeinheit in der Anordnung der Dispenserdüsen analog zur ersten Querachse begrenzt, kann die Druckeinheit vorzugsweise in dem Bereich zwischen der ersten und der zweiten Längsachse an die Konturen des zu bedruckenden Substrates angepasst werden. Bei Durchführung und Beendigung der Relativbewegung befindet sich die erste und die vierte Dispenserdüse exakt am Ende eines jeweils zu bedruckenden Bereiches des Substrates.

Vorteilhafterweise kann bei der Konstruktion der Druckeinheit berücksichtig werden, in welchem Winkel die Ecken eines Substrates mit einer Pseudo-Square-Form gegenüber den restlichen Kanten des Substrates abgefast sind, um den Verlauf der Schrägachse und damit auch die Anordnung der ersten und der vierten Dispenserdüse an den Verlauf der abgefasten Ecken des Substrates anzupassen. Ferner kann die Anordnung der ersten und der vierten Dispenserdüse bei der Montage der Vorrichtung zum Paralleldispensen dazu genutzt werden, die Druckeinheit auch durch unerfahrene Montagemitarbeiter unter Zuhilfenahme eines zu bedruckenden Substrates auszurichten. Dabei kann die Druckeinheit zumindest anhand der Schrägachse an eine Kante des Substrates angepasst werden.

In einer vorteilhaften Weiterbildung ist eine fünfte Dispenserdüse auf der zweiten Längsachse in Bewegungsrichtung in einem zweiten Düsenabstand zu der vierten Dispenserdüse angeordnet, wobei die zweite Längsachse die Dispensereinheit in einer Weise begrenzt, dass die Druckeinheit auf einer Seite der zweiten Längsachse frei von weiteren Dispenserdüsen ist.

Durch Ausgabe des Druckmediums aus der vierten und der fünften Dispenserdüse werden analog zu den Ausführungen zur ersten und dritten Dispenserdüse Drucklinien erzeugt, welche je nach relativem Verfahrweg der Relativbewegung zusammenhängend, überlappend oder koaxial voneinander beabstandet ausgestaltet sein können.

Grundsätzlich können der erste und der zweite Düsenabstand identisch oder unterschiedlich sein.

Sofern die Druckeinheit derart ausgestaltet ist, dass der erste und der zweite Düsenabstand identisch sind, lässt sich bei Ausgabe des Druckmediums durch die vierte und die fünfte Dispenserdüse ein identisches Drucklinienmuster erzeugen, wie durch die Ausgabe des Druckmediums durch die erste und die dritte Dispenserdüse.

Durch Ausgestaltung der Druckeinheit, bei der der erste und der zweite Düsenabstand unterschiedlich sind, ergibt sich durch die vierte und die fünfte Dispenserdüse gegebenenfalls ein anderes Drucklinienmuster als jenes, das mit der ersten und der dritten Dispenserdüse erzeugt wird. Dies ist insbesondere davon abhängig, in welchem Verhältnis der eingestellte relative Verfahrweg zu dem ersten und dem zweiten Düsenabstand gewählt ist.

Durch Einstellung eines relativen Verfahrweges, welcher kleiner ist als der geringere des ersten und des zweiten Düsenabstandes, erzeugen beide Dispenserdüsenpaare zwei Drucklinienpaare, mit jeweils zwei koaxialen Drucklinien, zwischen denen eine Lücke ausgebildet ist.

Durch Einstellung eines relativen Verfahrweges, welcher dem geringeren des ersten oder des zweiten Düsenabstandes entspricht, so erzeugt das Dispenserdüsenpaar mit dem geringeren Abstand eine zusammenhängende Drucklinie, welche aus zwei Drucklinien besteht, während das Dispenserdüsenpaar mit dem größeren Abstand zwei koaxial voneinander beabstandete Drucklinien erzeugt.

Durch Einstellung eines relativen Verfahrweges, welcher größer als der geringere des ersten und des zweiten Düsenabstandes ist, jedoch auch kleiner als der größere des ersten und des zweiten Düsenabstandes, so erzeugt das Dispenserdüsenpaar mit dem geringeren Abstand zwei zusammenhängende Drucklinien mit einem Überlappungsbereich, während das Dispenserdüsenpaar mit dem größeren Abstand zwei koaxial voneinander beabstandete Drucklinien erzeugt.

Durch Einstellung eines relativen Verfahrweges, welcher größer ist als der geringere des ersten und des zweiten Düsenabstandes und welcher zumindest dem größeren des ersten und des zweiten Düsenabstandes entspricht, so erzeugen beide Dispenserdüsenpaare zwei zusammenhängende Drucklinien, welche jeweils einen Überlappbereich aufweisen, von denen ein Überlappungsbereich länger ist als der andere.

Die zweite Längsachse, entlang welcher die vierte und die fünfte Dispenserdüse angeordnet sind, begrenzen die Anordnung der Dispenserdüsen auf der Druckeinheit in einer Weise, dass bei dem Druckvorgang zu einer Seite der zweiten Längsachse keine weiteren Drucklinien erzeugt werden.

In einer vorteilhaften Weiterbildung weist die Druckeinheit einen Randbereich auf, in dem eine Vielzahl an Dispenserdüsen, die vierte und die fünfte Disepenserdüse umfassend, entlang zumindest einer ersten Randreihe angeordnet sind, wobei die erste Randreihe, die vierte und die fünfte Dispenserdüse umfasst, und alle Dispenserdüsen der ersten Randreihe regelmäßig in einem zweiten Düsenabstand voneinander beanstandet sind.

Der Randbereich stellt einen Bereich der Druckeinheit der, in dem die Dispenserdüsen analog zum Mittenbereich in einer Fernordnung angeordnet werden können. Diese Fernordnung kann dadurch erreicht werden, dass die Dispenserdüsen, welche im Randbereich angeordnet werden, analog zur Ausgestaltung des Mittenbereiches in einer oder mehreren Randreihen angeordnet werden. Somit umfasst der Randbereich zumindest die erste Randreihe, deren Dispenserdüsen entlang der zweiten Längsachse ausgerichtet sind und deren Anordnung auf der Druckeinheit durch die Schrägachse beschränkt ist.

Besondere Vorteile gehen bei der Ausgestaltung eines Randbereiches einher, sofern es sich bei dem zu bedruckenden Substrat um ein Halbleitersubstrat handelt, welches eine Pseudo-Square-Form aufweist. Das Halbleitersubstrat kann dabei derart in der Vorrichtung angeordnet sein, dass der Randbereich der Druckeinheit bei der Relativbewegung denjenigen Teil des Halbleitersubstrates überstreicht, in welchem sich die abgefasten Ecken befinden und wobei der Mittenbereich der Druckeinheit denjenigen Teil des Halbleitersubstrates überstreicht, welcher in Bewegungsrichtung eine einheitliche und vorzugsweise größere Abmessung als der Bereich mit den abgefasten Ecken aufweist.

Vorteilhafterweise ist die Anzahl der Dispenserdüsen, welche in einer Randreihe des Randbereiches angeordnet sind, unterschiedlich zu der Anzahl der Dispenserdüsen, welche in einer Reihe des Mittenbereiches angeordnet sind. Vorteilhafterweise entspricht der erste Dispeserabstand dabei jedoch dem zweiten Düsenabstand, sodass sich der Unterschied zwischen dem Mittenbereich und dem Randbereich lediglich durch die Anzahl der Dispenserdüsen zwischen einer Reihe und einer Randreihe ergibt. Hierdurch wird eine maschinelle Fertigung der Druckeinheit vereinfacht, da für den Mittenbereich und für den Randbereich dieselben maschinellen Bearbeitungsparameter für die Erzeugung oder spätere Anordnung der Dispenserdüsen verwendet werden kann.

In einer vorteilhaften Weiterbildung umfassen die Randreihen jeweils insgesamt zwei Dispenserdüsen, welche in dem zweiten Düsenabstand voneinander beabstandet sind, wobei der erste Düsenabstand größer ist als der zweite Düsenabstand.

Untersuchungen der Anmelderin haben gezeigt, dass ein guter Kompromiss zwischen den Herstellungskosten einer Druckeinheit und den Kosten eines Antriebsmittels gefunden werden kann, wenn die Anzahl an Dispenserdüsen innerhalb einer Randreihe des Randbereiches die Anzahl von zwei nicht übersteigt.

Durch einen Unterschied zwischen dem ersten Düsenabstand und dem zweiten Dispenserabtand ist es auf einfache Weise möglich, das Substrat bereichsweise mit zwei unterschiedlichen Drucklinienmustern zu segmentieren, wobei jedoch ein und derselbe relative Verfahrweg zwischen Druckeinheit und Substrat eingestellt werden kann.

Durch die oben beschriebene Weiterbildung kann der Randbereich der Druckeinheit dazu genutzt werden, das Substrat mit einer durchgehenden Drucklinie zu bedrucken, welche sich aus den Drucklinien zusammensetzt, die durch die vierte und fünfte Dispenserdüse erzeugt werden. Gleichzeitig kann der Mittenbereich der Druckeinheit dazu genutzt werden, eine Mehrzahl an Drucklinien zu erzeugen, die nach Abschluss des Druckvorganges jeweils eine Unterbrechung in Form einer Lücke aufweisen. Besagte Lücke kann vorteilhafterweise zur Anbringung eines Datamatrixcodes oder als Sollunterbrechung zur Erzeugung einer Halbzelle im Falle eines bedruckten Halbleitersubstrates genutzt werden.

In einer vorteilhaften Weiterbildung weist die Druckeinheit zumindest eine erste Symmetrieachse und/oder eine zweite Symmetrieachse auf, wobei die erste Symmetrieachse parallel zur Bewegungsrichtung verläuft und die zweite Symmetrieachse orthogonal zur Bewegungsrichtung verläuft und wobei die Dispenserdüsen zumindest hinsichtlich der ersten oder der zweiten Symmetrieachse achssymmetrisch auf der Druckeinheit angeordnet sind.

Der Vorteil einer achssymmetrischen Anordnung der Dispenserdüsen auf der Druckeinheit liegt in der einfachen Konstruktion sowie Herstellbarkeit der Druckeinheit. Während der Konstruktion äußert sich dieser Vorteil darin, dass vorzugsweise nur eine Hälfte der Druckeinheit in Hinblick auf die Positionen der Dispenserdüsen konstruiert werden muss, und die jeweils andere Hälfte entsprechend der ersten Hälfte ausgestaltet wird. Sofern die Druckeinheit die zweite Symmetrieachse aufweist, wird der Konstruktionsaufwand weiter reduziert.

Eine symmetrische Anordnung der Dispenserdüsen geht ferner mit Vorteilen einher, wenn das zu bedruckende Substrat ebenfalls achssymmetrisch aufgebaut ist. Dies ist insbesondere bei einer Pseudo-Square-Form eines zu bedruckenden Halbleitersubstrates der Fall. Zur Aufbringung einer Mehrzahl an Drucklinien kann die Druckeinheit, deren Dispenserdüsenanordnung durch die erste Quereinheit und/oder die zweite Längsachse und/oder die Schrägachse begrenzt ist vollständig oberhalb des Substrates angeordnet werden. Aufgrund des symmetrischen Aufbaus der Druckeinheit kann unter geeigneter Auswahl der Gesamtabmessungen bei der Bedruckung eines ebenfalls symmetrisch ausgestalteten Substrates gewährleistet werden, dass während der gesamten Relativbewegung keine Dispenserdüse über das Substrat hinausragt.

In einer vorteilhaften Weiterbildung umfasst die Druckeinheit mindestens zwei Teileinheiten, wobei eine erste Teileinheit und eine zweite Teileinheit jeweils einen Teil aller Dispenserdüsen der Dispensereinheit umfassen und das Antriebsmittel dazu ausgestaltet ist, die erste und die zweite Teileinheit zur Erzeugung der Relativbewegung unabhängig voneinander zu verfahren.

Die Dispensereinheit kann grundsätzlich in beliebig viele Teileinheiten untergliederbar sein, welche unabhängig voneinenander verfahrbar sind. Die Relativbewegung setzt sich in diesem Fall aus einer Vielzahl an Teilbewegungen zusammen, bei denen die entsprechende Teileinheit gegenüber dem Substrat verlagert wird oder umgekehrt. Die Teilbewegungen erfolgen dabei jeweils in Bewegungsrichtung.

Sofern die Druckeinheit einen Mittenbereich und einen Randbereich aufweist, können die erste Teileinheit den Mittenbereich und die zweite Teileinheit den Randbereich der Druckeinheit umfassen. Ferner können auch nur der Mittenbereich und/oder der Randbereich jeweils in mindestens zwei Teileinheiten untergliedert sein.

Ferner liegt es im Rahmen der vorteilhaften Weiterbildung, dass zumindest die erste und die zweite Teileinheit durch eine Symmetrieachse der Druckeinheit getrennt sind. Dies geht mit Vorteilen in der Konstruktion der Teileinheiten einher, da lediglich eine Teileinheit konstruiert werden muss, während die jeweils andere Teileinheit lediglich symmetrisch zu der bereits konstruierten Teileinheit ausgeführt werden muss.

In einer vorteilhaften Weiterbildung umfasst die Druckeinheit einen Druckmediumeingang und zumindest einen Druckmediumkanal, wobei der Druckmediumeingang mit einem zentralen Absperrventil fluidleitend verbunden ist und im Bereich des Druckmediumkanals zumindest eine Düsenschiene austauschbar angeordnet ist, wobei die Düsenschiene zumindest einen Teil der Dispenserdüsen der Druckeinheit umfasst.

Der Druckmediumeingang dient dazu, die Druckeinheit mit einer Druckmediumvorsorgungseinheit fluidleitend zu verbinden und das Druckmedium über zumindest einen Druckmedumkanal zu einer Mehrzahl an Dispenserdüsen zu leiten, durch welche das Druckmedium auf das Substrat gelangt.

Das zentrale Absperrventil kann in Form eines elektrisch betätigbaren Ventils ausgestaltet sein, das zu Beginn der Relativbewegung, während welcher das Substrat mit einer Mehrzahl an Drucklinien bedruckt wird, geöffnet wird und bei Abschluss der Relativbewegung gesperrt wird.

Die Düsenschiene umfasst zumindest einen Teil der Dispenserdüsen und ist austauschbar im Bereich des Druckmediumkanals angeordnet. Besagte Autauschbarkeit kann formschlüssig z.B. durch eine Schnappverbindung oder kraftschlüssig, z.B. durch eine Klemmverbindung im Bereich des Druckmediumkanals angeordnet werden. Dies erlaubt es, die Düsenschiene unter geringem Aufwand durch eine andere Düsenschiene austauschen zu können. Die einfache Austauschbarkeit erlaubt ein hohes Maß an Verfügbarkeit der Druckvorrichtung in der industriellen Bedruckung von Substraten, insbesondere Halbleitersubstraten.

Die Erfindung betrifft auch ein Verfahren zum Paralleldispensen eines Druckmediums auf ein Substrat, insbesondere zur Herstellung einer oder mehrerer Leiterbahnen auf einem Halbleitersubstrat, mit einer Druckeinheit und einem Antriebsmittel, wobei das Antriebsmittel eine Relativbewegung zwischen der Druckeinheit und dem Substrat mit einer Bewegungsrichtung erzeugt, wobei das Druckmedium über eine erste Dispenserdüse und eine zweite Dispenserdüse und eine dritte Dispenserdüse, welche an der Druckeinheit angeordnet sind, gleichzeitig ausgegeben wird und dadurch auf das Substrat gelangt, wobei die erste Dispenserdüse eine erste Drucklinie mit einem ersten Startpunkt und einem ersten Endpunkt erzeugt und die zweite Dispenserdüse eine zweite Drucklinie mit einem zweiten Startpunkt und einem zweiten Endpunkt erzeugt, wobei die erste und die zweite Drucklinie parallel zueinander beabstandet auf das Substrat aufgebracht werden.

Wesentlich für das erfindungsgemäße Verfahren ist, dass die dritte Dispenserdüse eine dritte Drucklinie mit einem dritten Startpunkt und einem dritten Endpunkt erzeugt, wobei die erste Drucklinie koaxial zu der dritten Drucklinie verläuft und der erste Startpunkt von dem dritten Startpunkt in einem ersten Düsenabstand voneinander beabstandet ist.

Vorteilhafterweise ist die erfindungsgemäße Vorrichtung oder eine ihrer vorteilhaften Weiterbildungen dazu ausgestaltet, das erfindungsgemäße Verfahren durchzuführen.

Durch das erfindungsgemäße Verfahren lässt sich die Produktivität bei der Bedruckung eines Substrates, insbesondere eines Halbleitersubstrates deutlich erhöhen.

In einer vorteilhaften Weiterbildung wird zur Durchführung der Relativbewegung ein relativer Verfahrweg eingestellt, welcher in einer ersten Verfahrensalternative kleiner ist als der erste Düsenabstand und zwischen der ersten und der dritten Drucklinie eine Lücke ausgestaltet wird.

Die Lücke zwischen den der ersten und der dritten Drucklinie kann zur Aufbringung einer Kennzeichnung des bedruckten Subtrates, z.B. eines DatamatrixCodes verwendet werden. Vorzugsweise handelt es sich bei dem Druckmedium um eine elektrisch leitende Paste, welche auf ein Halbleitersubstrat aufgebracht wird, um elektrisch leitfähige Kontaktierungsfinger auszubilden. Durch die Ausgestaltung der Lücke ist es möglich, das Halbleitersubstrat in den Bereichen der ersten und der dritten Drucklinie zu segmentieren.

In einer vorteilhaften Weiterbildung wird zur Durchführung der Relativbewegung ein relativer Verfahrweg eingestellt, welcher in einer ersten Verfahrensalternative zumindest dem ersten Düsenabstand entspricht und die erste Drucklinie und die dritte Drucklinie mit einem gemeinsamen Kontaktbereich, insbesondere einem Überlappungsbereich, ausgestaltet sind.

Ein Kontaktbereich zwischen der ersten und der dritten Drucklinie erlaubt die Erzeugung einer durchgehenden Drucklinie, welche sich aus der ersten und der dritten Drucklinie zusammensetzt. Dadurch verringert sich die erforderliche Zeit, um eine derart zusammengesetzten Drucklinie zu erzeugen, um die Hälfte. Sofern es sich bei den Drucklinien um elektrische Kontaktlinien handelt, erhöht der Überlappungsbereich die elektrische Leitfähigkeit der erzeugten zusammengesetzten Drucklinie.

Weitere bevorzugte Merkmale und Ausführungsformen der erfindungsgemäßen Vorrichtung und des erfindungsgemäßen Verfahrens werden im Folgenden anhand von Ausführungsbeispielen und den Figuren erläutert. Die Ausführungsbeispiele sind lediglich vorteilhafte Ausgestaltungen der Erfindung und nicht einschränkend.

Es zeigt:
- Figur 1: eine Vorrichtung zum Paralleldispensen in Seitenansicht
- Figur 2: eine Vorrichtung zum Paralleldispensen in Draufsicht, mit einer ersten Variante einer Druckeinheit;
- Figur 3: eine zweite Variante einer Druckeinheit;
- Figur 4: zwei Substrate, welches mittels der zweiten Variante der Druckeinheit auf unterschiedliche Weisen bedruckt sind;
- Figur 5: eine dritte Variante einer Druckeinheit;
- Figur 6: ein Substrat, welches mittels der dritten Variante einer Druckeinheit bedruckt ist;

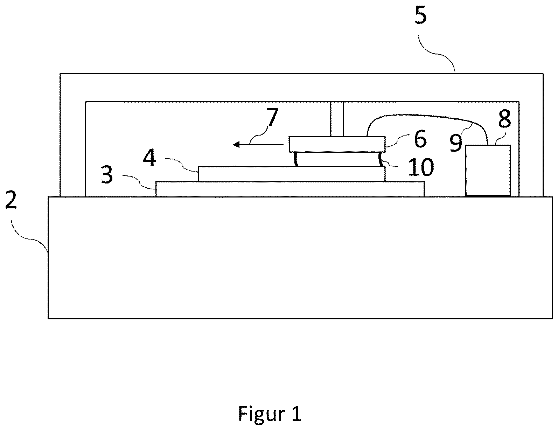

Figur 1 zeigt eine Vorrichtung 1 zum Paralleldispensen. Die Vorrichtung 1 umfasst ein Maschinenbett 2 und eine darauf angeordnete Substratauflage 3, welche dazu dient, ein zu bedruckendes Substrat 4 aufzunehmen und für einen Druckvorgang in einer definierten Position und Ausrichtung zu fixieren. Ein Antriebsmittel in Form einer Lineareinheit 5 ist an einem Gestell oberhalb der Substratauflage 3 und dem darauf befindlichen Substrat 4 angeordnet. Die Lineareinheit 5 weist einen beweglichen Schlitten auf, mit dem eine austauschbare erste Druckeinheit 6 gegenüber der Substratauflage 3 und dem Substrat 4 bewegt werden kann. Bei dem Substrat 4 handelt es sich um eine Halbleiterstruktur, vorliegend eine Halbleiterstruktur zur Ausbildung einer photovoltaischen Solarzelle.

Die Vorrichtung 1 weist ferner ein Druckmediumreservoir 8 mit einer nicht dargestellten Fördereinheit auf, welches über eine Förderleitung 9 mit der ersten Druckeinheit 6 fluidleitend verbunden ist. Die Fördereinheit kann als Pumpvorrichtung, z.B. als Kolbenpumpe ausgestaltet sein, welche ein im Druckmediumreservoir 8 befindliches Druckmedium 10 in die erste Druckeinheit 6 fördert. Das Druckmedium 10 gelangt dabei in eine Mehrzahl an Dispenserdüsen (nicht gezeigt) der ersten Druckeinheit 6, durch welche das Druckmedium auf die Oberfläche des Substrates 4 gelangt. Dabei wird eine Mehrzahl von Drucklinien erzeugt, von denen mindestens zwei koaxial zueinander verlaufen. Bei dem Druckmedium 10 handelt es sich um eine metallische Druckpaste zur Erzeugung elektrisch leitfähiger Kontaktfinger auf dem Substrat 4.

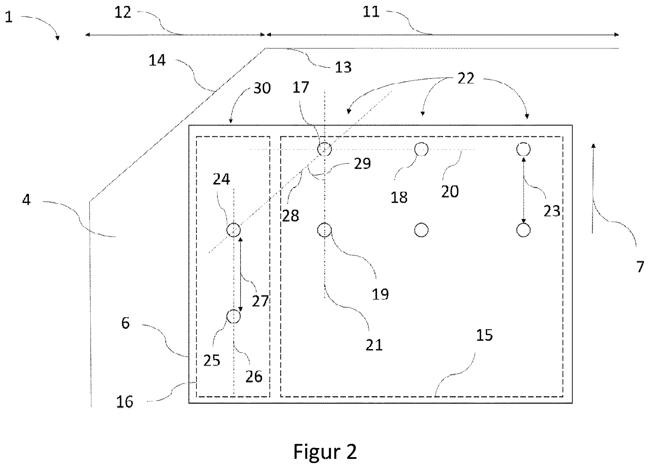

Figur 2 zeigt die erste Druckeinheit 6 und das Substrat 4 der Figur 1 in einer Draufsicht. Zur besseren Überschaubarkeit sind die restlichen Bestandteile der Vorrichtung 1 gemäß Figur 1 nicht gezeigt.

Die erste Druckeinheit 6 befindet sich entsprechend den Ausführungen zu Figur 1 oberhalb des Substrates 4 und wird in Bewegungsrichtung 7 gegenüber dem Substrat bewegt.

Das Substrat 4 weist eine Pseudo-Square-Form auf. Diese erlaubt die Aufgliederung des Substrates 4 in einen ersten Bereich 11 und einen zweiten Bereich 12. In dem ersten Bereich 11 ist das Substrat 4 durch eine geradlinige Kante 13 begrenzt, welche in der gezeigten Anordnung des Substrates 4 orthogonal zur Bewegungsrichtung 7 verläuft. Im zweiten Bereich 12 mündet besagte geradlinige Kante des ersten Bereiches 11 in eine zu der geradlinigen Kante 13 unter 45° abgewinkelten Fase 14.

Die Druckeinheit 6 ist mit einem Mittenbereich 15 und einem Randbereich 16 ausgestaltet. Bei der relativen Verlagerung der Druckeinheit 6 überstreicht diese mit dem Mittenbereich 15 den ersten Bereich 11 des Substrates 4, während der Randbereich 16 den zweiten Bereich 12 des Substrates 4 überstreicht.

Im Mittenbereich 15 weist die Druckeinheit 6 eine erste Dispenserdüse 17, eine zweite Dispenserdüse 18 und eine dritte Dispenserdüse 19 auf. Die erste Dispenserdüse 17 und die zweite Dispenserdüse 18 sind entlang einer gemeinsamen ersten Querachse 20 angeordnet, welche orthogonal zur Bewegungsrichtung 7 verläuft. Die erste Dispenserdüse 17 und die dritte Dispenserdüse 19 sind entlang einer gemeinsamen ersten Längsachse 21 angeordnet, welche parallel zur Bewegungsrichtung 7 verläuft.

Neben den obenstehend genannten Dispenserdüsen 17, 18 und 19 sind im Mittenbereich 15 weitere Dispenserdüsen entlang mehrerer Reihen 22 angeordnet. In den besagten Reihen 22 sind die Dispenserdüsen regelmäßig in einem ersten Düsenabstand 23 voneinander beabstandet.

Im Randbereich 16 sind eine vierte Dispenserdüse 24 und eine fünfte Dispenserdüse 25 entlang einer gemeinsamen zweiten Längsachse 26 angeordnet. Die zweite Längsachse 26 verläuft analog zu der ersten Längsachse 21 parallel zur Bewegungsrichtung 7. Die vierte und die fünfte Dispenserdüse 24 bzw. 25 sind im Ausführungsbeispiel gemäß Figur 2 die einzigen Dispenserdüsen, welche in einer Randreihe 30 des Randbereiches 16 in einem zweiten Düsenabstand 27 voneinander beabstandet angeordnet sind.

Ferner ist die erste Dispenserdüse 17 und die vierte Dispenserdüse 24 entlang einer gemeinsamen Schrägachse 28 angeordnet, welche in einem spitzen Winkel 29 gegenüber der Bewegungsrichtung 7 verläuft.

Wird die Druckeinheit 6 entlang der Bewegungsrichtung7 gegenüber dem Substrat 4 verlagert, so sind die Dispenserdüsen, welche im Mittenbereich 15 angeordnet sind, zumindest teilweise denjenigen Dispenserdüsen, welche in dem Randbereich 16 angeordnet sind, vorgelagert. Daraus ergibt sich der Vorteil, dass die Dispenserdüsen, welche im Randbereich 16 angeordnet sind, nach Abschluss der Relativbewegung zwischen der ersten Druckeinheit 6 und Substrat 4 nicht über das Substrat 4 hinausragen, wodurch Druckmedium verschwendet würde.

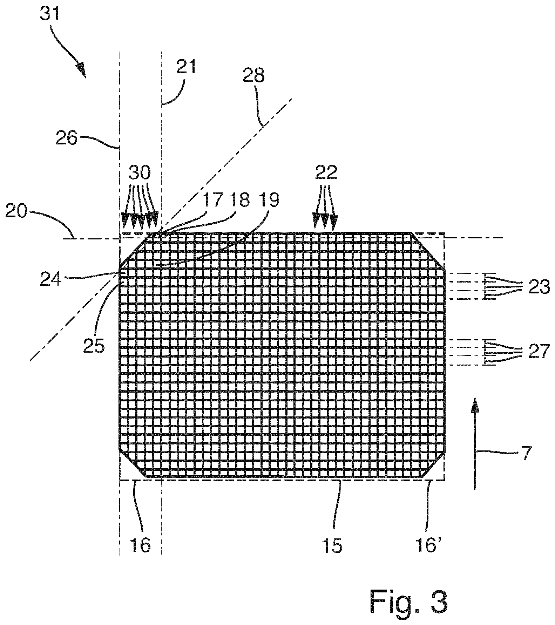

Figur 3 zeigt ein alternatives Ausführungsbeispiel für eine Druckeinheit in Form einer zweiten Druckeinheit 31, welche jedoch entsprechend den gleichen geometrischen Gesetzmäßigkeiten strukturiert ist, wie auch die erste Druckeinheit 6 gemäß Figur 2. Zur Verdeutlichung der Identität zwischen den geometrischen Gesetzmäßigkeiten werden zumindest teilweise dieselben Bezugszeichen verwendet, wie in Figur 2.

Die zweite Druckeinheit 31 weist analog zur ersten Druckeinheit 6 gemäß Figur 2 einen Mittenbereich 15 auf, in welchem eine Mehrzahl an Dispenserdüsen, umfassend eine erste Dispenserdüse 17, eine zweite Dispenserdüse 18 und eine dritte Dispenserdüse 19, in Reihen 22 regelmäßig zueinander beabstandet angeordnet sind. Die Abstände zweier benachbarter Dispenserdüsen, welche innerhalb einer Reihe 22 des Mittenbereiches 15 angeordnet sind, entsprechen jeweils einem ersten Düsenabstand 23.

Ferner weist die zweite Druckeinheit 31 zwei Randbereiche 16 und 16' auf, welche jeweils an den Mittenbereich 15 angrenzen. In den Randbereichen 16 und 16' sind die Dispenserdüsen spiegelsymmetrisch zueinander angeordnet sind. Dabei sind die Dispenserdüsen eines Randbereiches in mehreren Randreihen 30 (nur in Bezug auf Randbereich 16 gezeigt) angeordnet, in welchen sie jeweils regelmäßig in einem zweiten Düsenabstand 27 zueinander angeordnet sind, wobei der erste und der zweite Düsenabstand 23 bzw. 27 identisch sind.

Die Anzahl an Dispenserdüsen einer Reihe 22 des Mittenbereiches 15 ist höher als die Anzahl an Dispenserdüsen einer Randreihe 30 eines Randbereiches 16 oder 16`.

Die erste Dispenserdüse 17 ist mit der zweiten Dispenserdüse 18 auf einer gemeinsamen ersten Querachse 20 angeordnet, welche orthogonal zur Bewegungsrichtung 7 verläuft. Ferner ist die erste Dispenserdüse 17 mit der dritten Dispenserdüse 19 entlang einer gemeinsamen ersten Längsachse 21 angeordnet, welche parallel zur Bewegungsrichtung 7 verläuft. Die vierte Dispenserdüse 24 ist mit der fünften Dispenserdüse 25 entlang einer zweiten Längsachse 26 angeordnet, welche parallel zur Bewegungsrichtung 7 verläuft. Darüber hinaus ist die erste Dispenserdüse 17 auf einer gemeinsamen Schrägachse 28 mit der vierten Dispenserdüse 24 angeordnet.

Die erste Querachse 20, zweite Längsachse 24 und die Schrägachse 28 begrenzen die zweite Druckeinheit 21 derart, dass auf jeweils einer Seite der genannten Achsen keine Dispenserdüsen angeordnet sind.

Die zweite Druckeinheit 31 ist in der Anordnung, gemäß welcher sich die Dispenserdüsen auf ihr angeordnet sind, entlang einer ersten Symmetrieachse, welche parallel zur Bewegungsrichtung verläuft sowie einer zweiten Symmetrieachse, welche orthogonal zur Bewegungsrichtung 7 verläuft vollständig symmetrisch aufgebaut.

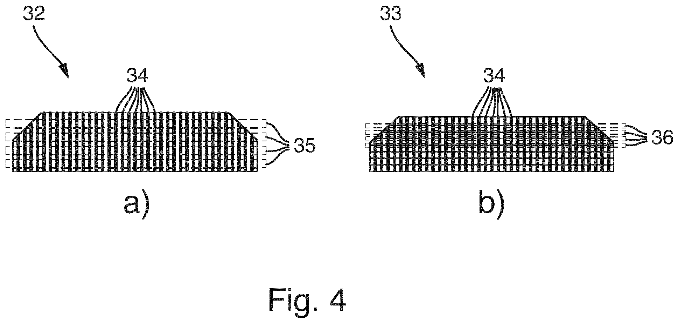

Wird die zweite Druckeinheit 31 in einer Relativbewegung mit der Bewegungsrichtung 7 gegenüber einem zu bedruckende Substrat verfahren, wobei ein Druckmedium durch die Dispenserdüsen ausgegeben wird, so ergeben sich, je nach eingestelltem relativen Verfahrweg zwischen der zweiten Druckeinheit 31 und Substrat, die Druckbilder, welche in Figur 4A und Figur 4B gezeigt sind.

Figur 4A zeigt ein erstes Halbleitersubstrat 32, welches mittels einer Vorrichtung bedruckt ist, bei der die Relativbewegung zwischen der zweiten Druckeinheit 31 (entsprechend Figur 3) mit einem relativen Verfahrweg durchgeführt wurde, welcher größer ist als der erste Düsenabstand 23 und der zweite Düsenabstand 27. Das Druckmedium, das während des Druckes aus den Dispenserdüsen der zweiten Druckeinheit 31 ausgegeben wurde und auf die Oberfläche des Halbleitersubstrates 32 gelangt ist, erzeugte dabei eine Mehrzahl an parallel zueinander verlaufender Drucklinien 34. Besagte Drucklinien 34 weisen in ihren Verläufen jeweils eine Mehrzahl an Überlappungsbereichen 35 auf. Die Überlappungsbereiche 35 entstehen, indem zumindest zwei in Bewegungsrichtung hintereinander angeordnete Dispenserdüsen während des Druckmediumsauftrags ein und denselben Bereich des Halbleitersubstrates 32 überstreichen. Bei den Drucklinien 34 handelt es sich um elektrisch leitfähige Kontaktfinger, sodass die Überlappungsbereiche 35 dazu dienen, einen niedrigen ohmschen Widerstandzwischen zwei koaxial aneinander angrenzenden Drucklinien zu bewirken.

Figur 4B zeigt ein zweites Halbleitersubstrat 33, welches ebenfalls mit einer Vorrichtung bedruckt wurde, bei der die Relativbewegung zwischen der zweiten Druckeinheit 31 (entsprechend Figur 2) mit einem relativen Verfahrweg durchgeführt wurde, welcher jedoch geringer ist als der erste Düsenabstand 23 und der zweite Düsenabstand 27. Das Druckmedium, das während des Druckes aus den Dispenserdüsen der zweiten Druckeinheit 31 ausgegeben wurde und auf die Oberfläche des Halbleitersubstrates 33 gelangt ist, erzeugte entsprechend den Ausführungen bezüglich Figur 4A eine Mehrzahl an parallel zueinander verlaufenden Drucklinien 34, welche jedoch im Gegensatz zu dem Halbleitersubstrat 32 gemäß Figur 4A jeweils durch eine Mehrzahl an Lücken 36 unterbrochen sind.

Die Lücken 36 können dazu dienen, die unterbrochenen Kontaktfingersegmente unabhängig voneinander mittels einer oder mehrere Busbars elektrisch zu kontaktieren oder eine Markierung z.B. in Form eines Datamatrixcodes auf dem Substrat aufzubringen.

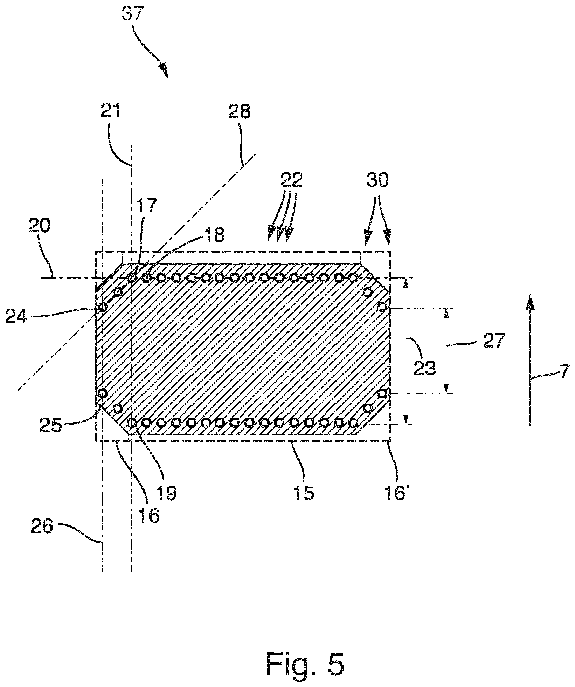

Figur 5 zeigt ein alternatives Ausführungsbeispiel für eine Druckeinheit in Form der dritten Druckeinheit 37, welche entsprechend den gleichen geometrischen Gesetzmäßigkeiten strukturiert ist, wie auch die erste Druckeinheit 6 gemäß Figur 2 sowie die zweite Druckeinheit 31 gemäß Figur 3. Zur Verdeutlichung der Identität zwischen den geometrischen Gesetzmäßigkeiten werden, wenn nicht anders erläutert, dieselben Bezugszeichen verwendet, wie in Figur 2 und 3.

Die dritte Druckeinheit 37 weist analog zur ersten Druckeinheit 6 gemäß Figur 2 sowie analog zur zweiten Druckeinheit 31 gemäß Figur 3 einen Mittenbereich 15 auf, in welchem eine Mehrzahl an Dispenserdüsen, umfassend eine erste Dispenserdüse 17, eine zweite Dispenserdüse 18 und eine dritte Dispenserdüse 19, in Reihen regelmäßig zueinander beabstandet angeordnet sind. Die Abstände zwischen zwei benachbarter Dispenserdüsen, welche innerhalb einer Reihe des Mittenbereiches 15 angeordnet sind, entsprechen einem ersten Düsenabstand 23.

Ferner weist die dritte Druckeinheit 37, analog zur zweiten Druckeinheit 21 zwei Randbereiche 16 und 16' auf, welche jeweils an den Mittenbereich 15 angrenzen. Die Randbereiche 16 und 16' weisen Dispenserdüsen auf, die hinsichtlich beider Randbereiche 16, 16' spiegelsymmetrisch angeordnet sind. Die Dispenserdüsen eines Randbereiches 16 oder 6` sind in mehreren Randreihen 30 (nur in Bezug auf Randbereich 16 gezeigt) angeordnet, in welchen sie im Gegensatz zur zweiten Druckeinheit 31 gemäß Figur 3 unregelmäßig in verschiedenen Abständen angeordnet sind, welche kleiner sind als der erste Düsenabstand 23.

Die erste Dispenserdüse 17 ist mit der zweiten Dispenserdüse 18 auf einer gemeinsamen ersten Querachse 20 angeordnet, welche orthogonal zur Bewegungsrichtung 7 verläuft. Ferner ist die erste Dispenserdüse 17 mit der dritten Dispenserdüse 19 entlang einer gemeinsamen ersten Längsachse 21 angeordnet, welche parallel zur Bewegungsrichtung 7 verläuft. Die vierte Dispenserdüse 24 ist mit der fünften Dispenserdüse 25 entlang einer zweiten Längsachse 26 angeordnet, welche parallel zur Bewegungsrichtung 7 verläuft. Darüber hinaus ist die erste Dispenserdüse 17 auf einer gemeinsamen Schrägachse 28 mit der vierten Dispenserdüse 24 angeordnet.

Die erste Querachse 20, zweite Längsachse 24 und die die Schrägachse 28 begrenzen die dritte Druckeinheit 37 derart, dass zu jeweils einer Seite der genannten Achsen keine Dispenserdüsen angeordnet sind.

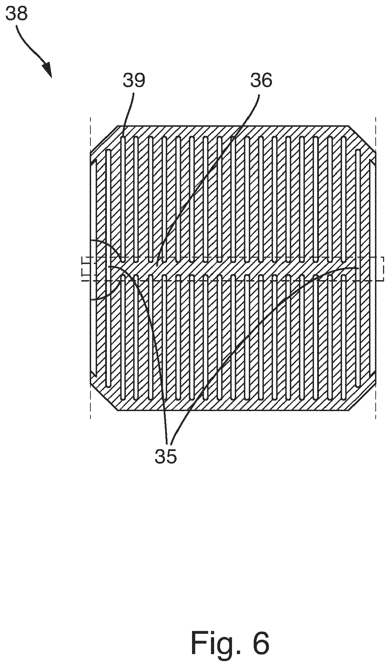

Wird die dritte Druckeinheit 37 in einer Relativbewegung mit der Bewegungsrichtung 7 gegenüber einem zu bedrucken Substrat verfahren, wobei ein Druckmedium durch die Dispenserdüsen auf das Substrat aufgetragen wird, so ergeben sich, bei einem relativen Verfahrweg, welcher geringer ist als der erste Düsenabstand, jedoch größer ist als der Abstand der Dispenserdüsen in den Randbereichen ein Druckbild gemäß Figur 6.

Figur 6 zeigt ein Halbleitersubstrat 38, welches mittels einer Vorrichtung bedruckt wurde, bei der die Relativbewegung zwischen der dritten Druckeinheit 37 (entsprechend Figur 5) durchgeführt wurde. Das Druckmedium, das während des Druckes aus den Dispenserdüsen der dritten Druckeinheit 37 auf das Halbleitersubstrat 38 aufgetragen wurde, erzeugte dabei eine Mehrzahl an parallel zueinander verlaufender Drucklinien 39. Besagte Drucklinien 39 weisen in ihren Verläufen sowohl eine Mehrzahl an Überlappungsbereichen 35 als auch eine Mehrzahl an Lücken 36 auf, welche in einem einzigen Verfahrensschritt durch lediglich eine Relativbewegung zwischen dem Halbleitersubstrat 38 und der dritten Druckeinheit 37 erzeugt wurde.

## Patentansprüche

1. Vorrichtung zum Paralleldispensen (1) eines Druckmediums (10) auf ein Substrat (4), insbesondere zur Herstellung einer oder mehrerer Leiterbahnen auf einem Halbleitersubstrat (4), mit einer Druckeinheit (6), welche eine Mehrzahl von Dispenserdüsen (17, 18, 19, 24, 25) zur gleichzeitigen Ausgabe des Druckmediums (10) umfasst, und einem Antriebsmittel (5), welches dazu ausgestaltet ist, eine Relativbewegung zwischen der Druckeinheit (6) und dem Substrat (4) in einer Bewegungsrichtung (7) zu erzeugen, wobei zumindest eine erste Dispenserdüse (17) und eine zweite Dispenserdüse (18) quer zur Bewegungsrichtung (7) voneinander beabstandet angeordnet sind,
**dadurch gekennzeichnet, dass**
die erste Dispenserdüse (17) und eine dritte Dispenserdüse (19) der Druckeinheit (6) entlang einer gemeinsamen ersten Längsachse (21) in einem ersten Düsenabstand (23) voneinander beabstandet angeordnet sind, wobei die erste Längsachse (21) parallel zu der Bewegungsrichtung (7) verläuft.

2. Vorrichtung nach Anspruch 1,
**dadurch gekennzeichnet, dass**
die erste Dispenserdüse (17) und die zweite Dispenserdüse (18) entlang einer gemeinsamen ersten Querachse (20) angeordnet sind, wobei die erste Querachse (20) orthogonal zu der Bewegungsrichtung (7) verläuft und die erste Querachse (20) die Druckeinheit (6) in einer Weise begrenzt, dass die Druckeinheit (6) auf einer Seite der ersten Querachse (20) frei von weiteren Dispenserdüsen ist.

3. Vorrichtung nach Anspruch 1 oder 2,
**dadurch gekennzeichnet, dass**
die Druckeinheit (6) einen Mittenbereich (15) aufweist, in dem eine Vielzahl an Dispenserdüsen, umfassend die erste, zweite und dritte Dispenserdüse (17 bzw. 18 bzw. 19), entlang mehrerer parallel zueinander verlaufender Reihen (22) angeordnet sind, wobei die erste und die dritte Dispenserdüse (17 bzw. 19) in einer gemeinsamen ersten Reihe angeordnet sind und die zweite Dispenserdüse (18) in einer anderen Reihe angeordnet ist, und alle Dispenserdüsen einer Reihe im Mittenbereich (15) regelmäßig in dem ersten Düsenabstand (23) voneinander beabstandet sind.

4. Vorrichtung nach Anspruch 3,
**dadurch gekennzeichnet, dass**
die Anzahl der Reihenim Mittenbereich (15) mindestens 60, vorzugsweise mindestens 80, höchstvorzugsweise mindestens 100 beträgt.

5. Vorrichtung nach Anspruch 3 oder 4,
**dadurch gekennzeichnet, dass**
eine Reihe im Mittenbereich (15) jeweils insgesamt zwei Dispenserdüsen umfasst, welche in dem ersten Düsenabstand (23) voneinander beabstandet sind.

6. Vorrichtung nach einem der voranstehenden Ansprüche,
**dadurch gekennzeichnet, dass**
eine vierte Dispenserdüse (24) auf einer zweiten Längsachse (26) angeordnet ist, wobei die erste Längsachse (21) und die zweite Längsachse (26) parallel zueinander beabstandet verlaufen und die erste und die vierte Dispenserdüse (17 bzw. 24) entlang einer gemeinsamen Schrägachse (28) angeordnet sind, wobei die Schrägachse (28) in einem Winkel zwischen Null Grad und Neunzig Grad zur Bewegungsrichtung verläuft und die Schrägachse (28) die Druckeinheit (6) in einer Weise begrenzt, dass die Druckeinheit (6) auf einer Seite der Schrägachse, vorzugsweise in einem Bereich zwischen der ersten und zweiten Längsachse, frei von weiteren Dispenserdüsen ist.

7. Vorrichtung nach Anspruch 6,
**dadurch gekennzeichnet, dass**
eine fünfte Dispenserdüse (25) auf der zweiten Längsachse (26) in einem zweiten Düsenabstand (27) zu der vierten Dispenserdüse (24) angeordnet ist und die zweite Längsachse (26) die Druckeinheit (6) in einer Weise begrenzt, dass die Druckeinheit (6) auf einer Seite der zweiten Längsachse (26) frei von weiteren Dispenserdüsen ist.

8. Vorrichtung nach Anspruch 7,
**dadurch gekennzeichnet, dass**
die Druckeinheit (6) einen Randbereich (16) aufweist, in dem eine Vielzahl an Dispenserdüsen umfassend die vierte und die fünfte Disepenserdüse (24 bzw. 25), entlang zumindest einer ersten Randreihe angeordnet sind, wobei die erste Randreihe, zumindest die vierte und die fünfte Dispenserdüse umfasst, und alle Dispenserdüsen der Randreihen, welche im Randbereich (16) angeordnet sind, regelmäßig in einem zweiten Düsenabstand (27) voneinander beanstandet sind.

9. Vorrichtung nach Anspruch 8,
**dadurch gekennzeichnet, dass**
die Randreihen jeweils insgesamt zwei Dispenserdüsen umfassen, welche in dem zweiten Düsenabstand (27) voneinander beabstandet sind und der erste Düsenabstand (23) größer ist als der zweite Düsenabstand (27).

10. Vorrichtung nach einem der voranstehenden Ansprüche,
**dadurch gekennzeichnet, dass**
die Druckeinheit (6) zumindest eine erste Symmetrieachse und/oder eine zweite Symmetrieachse auf, wobei die erste Symmetrieachse parallel zur Bewegungsrichtung verläuft und die zweite Symmetrieachse orthogonal zur Bewegungsrichtung verläuft, wobei die Dispenserdüsen zumindest hinsichtlich der ersten oder der zweiten Symmetrieachse achssymmetrisch auf der Druckeinheit (6) angeordnet sind.

11. Vorrichtung nach einem der voranstehenden Ansprüche,
**dadurch gekennzeichnet, dass**
die Dispensereinheit (6) mindestens zwei Teileinheiten umfasst, wobei eine erste Teileinheit und eine zweite Teileinheit jeweils einen Teil aller Dispenserdüsen der Dispensereinheit (6) umfassen und das Antriebsmittel (5) dazu ausgestaltet ist, die erste und die zweite Teileinheit zur Erzeugung der Relativbewegung unabhängig voneinander zu verfahren.

12. Vorrichtung nach einem der voranstehenden Ansprüche,
**dadurch gekennzeichnet, dass**
die Druckeinheit (6) einen Druckmediumeingang und einen Druckmediumkanal umfasst, wobei der Druckmediumeingang mit einem zentralen Absperrventil fluidleitend verbunden ist und im Bereich des Druckmediumkanals zumindest eine Düsenschiene anordbar ist, wobei die Düsenschiene zumindest einen Teil der Dispenserdüsen der Druckeinheit umfasst.

13. Verfahren zum Paralleldispensen eines Druckmediums (10) auf ein Substrat (4), insbesondere zur Herstellung einer oder mehrerer Leiterbahnen auf einem Halbleitersubstrat, mit einer Druckeinheit (6) und einem Antriebsmittel (5), wobei
- das Antriebsmittel (5) eine Relativbewegung zwischen der Druckeinheit (6) und dem Substrat (4) mit einer Bewegungsrichtung (7) erzeugt, wobei
- das Druckmedium (10) über eine erste Dispenserdüse (17) und eine zweite Dispenserdüse (18) und eine dritte Dispenserdüse (19), welche an der Druckeinheit (6) angeordnet sind, gleichzeitig ausgegeben wird und dadurch auf das Substrat (4) gelangt, wobei
- die erste Dispenserdüse (17) eine erste Drucklinie mit einem ersten Startpunkt und einem ersten Endpunkt erzeugt und die zweite Dispenserdüse eine zweite Drucklinie mit einem zweiten Startpunkt und einem zweiten Endpunkt erzeugt, wobei die erste und die zweite Drucklinie parallel zueinander beabstandet auf das Substrat aufgebracht werden
**dadurch gekennzeichnet, dass**
- die dritte Dispenserdüse (19) eine dritte Drucklinie mit einem dritten Startpunkt und einem dritten Endpunkt erzeugt, wobei die erste Drucklinie koaxial zu der dritten Drucklinie verläuft und
- der erste Startpunkt von dem dritten Startpunkt in einem ersten Düsenabstand (23) beabstandet ist.

14. Verfahren nach Anspruch 13,
**dadurch gekennzeichnet, dass**
zur Durchführung der Relativbewegung ein relativer Verfahrweg eingestellt wird, welcher in einer ersten Verfahrensalternative geringer ist als der erste Düsenabstand (23) und zwischen der ersten und der dritten Drucklinie eine Lücke (36) ausgestaltet wird.

15. Verfahren nach Anspruch 13 oder 14,
**dadurch gekennzeichnet, dass**
zur Durchführung der Relativbewegung ein relativer Verfahrweg eingestellt wird, welcher in einer zweiten Verfahrensalternative zumindest dem ersten Düsenabstand (23) entspricht und die erste Drucklinie und die dritte Drucklinie mit einem gemeinsamen Kontaktbereich, insbesondere einem Überlappungsbereich (35), ausgestaltet sind.

## Claims

1. Device (1) for parallel dispensing of a print medium (10) onto a substrate (4), in particular for producing one or more conductor tracks on a semiconductor substrate (4), with a printing unit (6) which comprises a multitude of dispenser nozzles (17, 18, 19, 24, 25) for simultaneous discharge of the print medium (10), and a driving means (5) formed to generate a relative movement between the printing unit (6) and the substrate (4) in a movement direction (7), wherein at least a first dispenser nozzle (17) and a second dispenser nozzle (18) are arranged spaced apart from one another transversely in relation to the movement direction (7),
**characterized in that**
the first dispenser nozzle (17) and a third dispenser nozzle (19) of the printing unit (6) are arranged spaced apart from one another along a common first longitudinal axis (21) at a first nozzle spacing (23), wherein the first longitudinal axis (21) runs parallel to the movement direction (7).

2. Device according to claim 1,
**characterized in that**
the first dispenser nozzle (17) and the second dispenser nozzle (18) are arranged along a common first transverse axis (20), wherein the first transverse axis (20) runs orthogonally in relation to the movement direction (7) and the first transverse axis (20) delimits the printing unit (6) such that the printing unit (6) is free of further dispenser nozzles on one side of the first transverse axis (20).

3. Device according to claim 1 or 2,
**characterized in that**
the printing unit (6) has a center region (15) in which a plurality of dispenser nozzles, comprising the first, second and third dispenser nozzles (17, 18 and 19, respectively), are arranged along multiple rows (22) that run parallel to one another, wherein the first and the third dispenser nozzle (17 and 19, respectively) are arranged in a common first row and the second dispenser nozzle (18) is arranged in another row, and all of the dispenser nozzles of one row in the center region (15) are evenly spaced apart from one another by the first nozzle spacing (23).

4. Device according to claim 3,
**characterized in that**
the number of rows in the center region (15) is at least 60, preferably at least 80, most preferably at least 100.

5. Device according to claim 3 or 4,
**characterized in that**
each row in the center region (15) comprises a total of two dispenser nozzles which are spaced apart from one another by the first nozzle spacing (23).

6. Device according to any of the preceding claims,
**characterized in that**
a fourth dispenser nozzle (24) is arranged on a second longitudinal axis (26), wherein the first longitudinal axis (21) and the second longitudinal axis (26) run spaced apart from and parallel to one another, and the first and the fourth dispenser nozzle (17 and 24, respectively) are arranged along a common oblique axis (28), wherein the oblique axis (28) runs at an angle between zero degrees and ninety degrees in relation to the movement direction and the oblique axis (28) delimits the printing unit (6) such that the printing unit (6) is free of further dispenser nozzles on one side of the oblique axis, preferably in a region between the first and second longitudinal axes.

7. Device according to claim 6,
**characterized in that**
a fifth dispenser nozzle (25) is arranged on the second longitudinal axis (26) at a second nozzle spacing (27) in relation to the fourth dispenser nozzle (24), and the second longitudinal axis (26) delimits the printing unit (6) such that the printing unit (6) is free of further dispenser nozzles on one side of the second longitudinal axis (26).

8. Device according to claim 7,
**characterized in that**
the printing unit (6) has a peripheral region (16) in which a plurality of dispenser nozzles, comprising the fourth and the fifth dispenser nozzle (24 and 25, respectively), are arranged along at least a first peripheral row, wherein the first peripheral row comprises at least the fourth and the fifth dispenser nozzle, and all of the dispenser nozzles of the peripheral rows arranged in the peripheral region (16) are evenly spaced apart from one another by a second nozzle spacing (27).

9. Device according to claim 8,
**characterized in that**
the peripheral rows each comprise a total of two dispenser nozzles which are spaced apart from one another by the second nozzle spacing (27) and the first nozzle spacing (23) is larger than the second nozzle spacing (27).

10. Device according to any of the preceding claims,
**characterized in that**
the printing unit (6) has at least a first axis of symmetry and/or a second axis of symmetry, wherein the first axis of symmetry runs parallel to the movement direction and the second axis of symmetry runs orthogonally in relation to the movement direction, wherein the dispenser nozzles are arranged on the printing unit (6) axially symmetrically at least in terms of the first or the second axis of symmetry.

11. Device according to any of the preceding claims,
**characterized in that**
the dispenser unit (6) comprises at least two sub-units, wherein a first sub-unit and a second sub-unit each comprise some of all the dispenser nozzles of the dispenser unit (6), and the driving means (5) is formed to move the first and the second sub-unit independently of one another to generate the relative movement.

12. Device according to any of the preceding claims,
**characterized in that**
the printing unit (6) comprises a print medium inlet and a print medium channel, wherein the print medium inlet is fluidically connected to a central shut-off valve and at least one nozzle rail is arranged in the region of the print medium channel, wherein the nozzle rail comprises at least some of the dispenser nozzles of the printing unit.

13. Method for parallel dispensing of a print medium (10) onto a substrate (4), in particular for producing one or more conductor tracks on a semiconductor substrate, with a printing unit (6) and a driving means (5), wherein
- the driving means (5) generates a relative movement between the printing unit (6) and the substrate (4) in a movement direction (7), wherein
- the print medium (10) is simultaneously discharged through a first dispenser nozzle (17) and a second dispenser nozzle (18) and a third dispenser nozzle (19), which are arranged on the printing unit (6), and as a result reaches the substrate (4), wherein
- the first dispenser nozzle (17) generates a first printed line with a first starting point and a first end point, and the second dispenser nozzle generates a second printed line with a second starting point and a second end point, wherein the first and the second printed line are applied to the substrate spaced apart and parallel to one another, **characterized in that**
- the third dispenser nozzle (19) generates a third printed line with a third starting point and a third end point, wherein the first printed line runs coaxially with the third printed line and
- the first starting point is spaced apart from the third starting point by a first nozzle spacing (23).

14. Method according to claim 13,
**characterized in that**
to perform the relative movement, a relative displacement travel which is smaller than the first nozzle spacing (23) in a first method alternative is set and a gap (36) is formed between the first and the third printed line.

15. Method according to claim 13 or 14,
**characterized in that**
to perform the relative movement, a relative displacement travel which corresponds to at least the first nozzle spacing (23) in a second method alternative is set and the first printed line and the third printed line are formed with a common contact region, in particular an overlap region (35).

## Revendications

1. Dispositif destiné à la distribution parallèle (1) d'un milieu de pression (10) sur un substrat (4), en particulier destiné à la production d'une ou de plusieurs pistes conductrices sur un substrat à semi-conducteurs (4), avec une unité de pression (6) qui comprend une pluralité de buses de distribution (17, 18, 19, 24, 25) destinées à la libération simultanée du milieu de pression (10), et un moyen d'entraînement (5) qui est conçu pour générer un mouvement relatif entre l'unité de pression (6) et le substrat (4) dans une direction de mouvement (7), dans lequel au moins une première buse de distribution (17) et une seconde buse de distribution (18) sont disposées espacées l'une de l'autre transversalement à la direction de mouvement (7),
**caractérisé en ce que**
la première buse de distribution (17) et une troisième buse de distribution (19) de l'unité de pression (6) sont disposées espacées l'une de l'autre le long d'un premier axe longitudinal commun (21) à une première distance entre les buses (23), dans lequel le premier axe longitudinal (21) s'étend parallèlement à la direction de mouvement (7).

2. Dispositif selon la revendication 1,
**caractérisé en ce que**
la première buse de distribution (17) et la seconde buse de distribution (18) sont disposées le long d'un premier axe transversal commun (20), dans lequel le premier axe transversal (20) s'étend orthogonalement à la direction de mouvement (7), et le premier axe transversal (20) délimite l'unité de pression (6) de telle sorte que l'unité de pression (6) soit exempte de buses de distribution supplémentaires sur un côté du premier axe transversal (20).

3. Dispositif selon la revendication 1 ou 2,
**caractérisé en ce que**
l'unité de pression (6) présente une zone centrale (15) dans laquelle une pluralité de buses de distribution, comprenant la première, la deuxième et la troisième buse de distribution (17, 18 et 19 respectivement), sont disposées le long de plusieurs rangées (22) s'étendant parallèlement les unes aux autres, dans lequel la première et la troisième buse de distribution (17 et 19 respectivement) sont disposées dans une première rangée commune et la deuxième buse de distribution (18) est disposée dans une autre rangée, et toutes les buses de distribution d'une rangée sont espacées les unes des autres dans la zone centrale (15) de manière régulière dans le premier espacement entre les buses (23).

4. Dispositif selon la revendication 3,
**caractérisé en ce que**
le nombre de rangées dans la zone centrale (15) est d'au moins 60, de préférence d'au moins 80, le plus préférentiellement d'au moins 100.

5. Dispositif selon la revendication 3 ou 4,
**caractérisé en ce que**
une rangée dans la zone centrale (15) comprend respectivement au total deux buses de distribution, lesquelles sont espacées l'une de l'autre dans le premier espacement entre les buses (23).

6. Dispositif selon l'une quelconque des revendications précédentes,
**caractérisé en ce que**
une quatrième buse de distribution (24) est disposée sur un second axe longitudinal (26), dans lequel le premier axe longitudinal (21) et le second axe longitudinal (26) s'étendent à distance parallèlement l'un à l'autre et la première et la quatrième buse de distribution (17 et 24 respectivement) sont disposées le long d'un axe oblique commun (28), dans lequel l'axe oblique (28) s'étend selon un angle entre zéro degré et quatre-vingt-dix degrés par rapport à la direction de mouvement et l'axe oblique (28) délimite l'unité de pression (6) de telle sorte que l'unité de pression (6) soit exempte d'autres buses de distribution sur un côté de l'axe oblique, de préférence dans une zone entre le premier et le second axe longitudinal.

7. Dispositif selon la revendication 6,
**caractérisé en ce que**
une cinquième buse de distribution (25) est disposée sur le second axe longitudinal (26) à un second espacement entre les buses (27) par rapport à la quatrième buse de distribution (24) et le second axe longitudinal (26) délimite l'unité de pression (6) de telle sorte que l'unité de pression (6) soit exempte d'autres buses de distribution sur un côté du second axe longitudinal (26).

8. Dispositif selon la revendication 7,
**caractérisé en ce que**
l'unité de pression (6) présente une zone périphérique (16) dans laquelle une pluralité de buses de distribution comprenant la quatrième et la cinquième buse de distribution (24 et 25 respectivement) sont disposées le long d'au moins une première rangée périphérique, dans lequel la première rangée périphérique comprend au moins la quatrième et la cinquième buse de distribution, et toutes les buses de distribution des rangées périphériques qui sont disposées dans la zone périphérique(16) sont espacées les unes des autres de manière régulière dans un second espacement entre les buses (27).

9. Dispositif selon la revendication 8,
**caractérisé en ce que**
les rangées périphériques comprennent respectivement au total deux buses de distribution qui sont espacées l'une de l'autre dans le second espacement entre les buses (27), et le premier espacement entre les buses (23) est plus grand que le second espacement entre les buses (27).

10. Dispositif selon l'une quelconque des revendications précédentes,
**caractérisé en ce que**
l'unité de pression (6) présente au moins un premier axe de symétrie et/ou un second axe de symétrie, dans lequel le premier axe de symétrie s'étend parallèlement à la direction de mouvement et le second axe de symétrie s'étend orthogonalement à la direction de mouvement, dans lequel les buses de distribution sont disposées de manière axisymétrique sur l'unité de pression (6) au moins par rapport au premier ou au second axe de symétrie.

11. Dispositif selon l'une quelconque des revendications précédentes,
**caractérisé en ce que**
l'unité de distribution (6) comprend au moins deux sous-unités, dans lequel une première sous-unité et une seconde sous-unité comprennent respectivement une partie de toutes les buses de distribution de l'unité de distribution (6), et le moyen d'entraînement (5) est conçu pour déplacer la première et la seconde sous-unité indépendamment l'une de l'autre pour générer le mouvement relatif.

12. Dispositif selon l'une quelconque des revendications précédentes,
**caractérisé en ce que**
l'unité de pression (6) comprend une entrée de milieu de pression et un canal de milieu de pression, dans lequel l'entrée de milieu de pression est reliée de manière fluidique à une vanne d'arrêt centrale et au moins un rail de buse peut être disposé dans la zone du canal de milieu de pression, dans lequel le rail de buse comprend au moins une partie des buses de distribution de l'unité de pression.

13. Procédé destiné à la distribution parallèle d'un milieu de pression (10) sur un substrat (4), en particulier destiné à la production d'une ou de plusieurs pistes conductrices sur un substrat à semi-conducteurs, avec une unité de pression (6) et un moyen d'entraînement (5), dans lequel
- le moyen d'entraînement (5) génère un mouvement relatif entre l'unité de pression (6) et le substrat (4) avec une direction de mouvement (7), dans lequel
- le milieu de pression (10) est délivré simultanément par le biais d'une première buse de distribution (17) et d'une deuxième buse de distribution (18) et d'une troisième buse de distribution (19) qui sont disposées au niveau de l'unité de pression (6), et de ce fait atteint le substrat (4), dans lequel
- la première buse de distribution (17) génère une première ligne de pression avec un premier point de départ et un premier point de fin et la deuxième buse de distribution génère une deuxième ligne de pression avec un deuxième point de départ et un deuxième point de fin, dans lequel la première et la deuxième ligne de pression sont espacées parallèlement l'une à l'autre et appliquées sur le substrat, **caractérisé en ce que**
- la troisième buse de distribution (19) génère une troisième ligne de pression avec un troisième point de départ et un troisième point de fin, dans lequel la première ligne de pression s'étend coaxialement à la troisième ligne de pression et
- le premier point de départ est espacé du troisième point de départ dans un premier espacement entre les buses (23).

14. Procédé selon la revendication 13,
**caractérisé en ce que**
pour la réalisation du mouvement relatif, une course de déplacement relatif qui est plus étroite que le premier espacement entre les buses (23) dans une première alternative de procédé est définie, et un vide (36) est formé entre la première et la troisième lignes de pression.

15. Procédé selon la revendication 13 ou 14,
**caractérisé en ce que**
pour la réalisation du mouvement relatif, une course de déplacement relatif qui correspond au moins au premier espacement entre les buses (23) dans une deuxième alternative de procédé est définie, et la première ligne de pression et la troisième de pression sont formées avec une zone de contact commune, en particulier une zone de chevauchement (35).
